# EUROPÄISCHE PATENTANMELDUNG

(11) **EP 3 923 685 A1**
(43) Veröffentlichungstag der Anmeldung: **15.12.2021**
(21) Anmeldenummer: 21178136.4
(22) Anmeldetag: 08.06.2021
(51) Int. Cl.: H05K 3/20

(54) **VERFAHREN ZUM HERSTELLEN EINES BAUTEILS MIT INTEGRIERTER SIGNALÜBERTRAGUNGSFUNKTION UND BAUTEIL MIT INTEGRIERTER SIGNALÜBERTRAGUNGSFUNKTION**

(30) Priorität: 09.06.2020 DE 102020115283
(71) Anmelder: Lisa Dräxlmaier GmbH, 84137 Vilsbiburg (DE)
(72) Erfinder: KRAXENBERGER, Christian, 5274 Burgkirchen (AT)

(57) **Zusammenfassung**

Die Erfindung betrifft ein Verfahren zum Herstellen eines Bauteils (10) mit integrierter Signalübertragungsfunktion, bei welchem eine Signalübertragungsstruktur (12) mit mehreren elektrischen Leitern (14) bereitgestellt und in ein elektrisch isolierendes Trägermaterial (16) eingebettet wird, wobei am Bauteil (10) zumindest eine Schnittstelle (18) zum Einspeisen von Signalen in die Leiter (14) und/oder zum Auslesen von Signalen aus den Leitern (14) hergestellt wird. Die Erfindung betrifft des Weiteren ein Bauteil (10) mit integrierter Signalübertragungsfunktion.

## Beschreibung

### Technisches Gebiet

Die vorliegende Erfindung betrifft ein Verfahren zum Herstellen eines Bauteils mit integrierter Signalübertragungsfunktion und ein Bauteil mit integrierter Signalübertragungsfunktion.

### Stand der Technik

Signale innerhalb von Komponenten zu übertragen erfordert meistens einen relativ hohen Aufwand, zudem steigen zunehmend die Anforderungen an mechanische Belastbarkeiten von Komponenten. Oftmals werden konventionelle Leitungssätze oder auch flexible Leiterplatten in solche Komponenten eingesetzt. Dies erfordert meistens manuelle Tätigkeiten im Fertigungsprozess und verursacht entsprechende Kosten.

### Beschreibung der Erfindung

Es ist daher die Aufgabe der vorliegenden Erfindung, eine Lösung bereitzustellen, mittels welcher auf besonders einfache und zuverlässige Weise eine Signalübertragungsfunktion in einem Bauteil realisiert werden kann.

Diese Aufgabe wird durch ein Verfahren zum Herstellen eines Bauteils mit integrierter Signalübertragungsfunktion sowie durch ein Bauteil mit integrierter Signalübertragungsfunktion mit den Merkmalen der unabhängigen Ansprüche gelöst. Weitere mögliche Ausgestaltungen der Erfindung sind in den Unteransprüchen, in der Beschreibung und den Figuren angegeben.

Bei dem erfindungsgemäßen Verfahren zum Herstellen eines Bauteils mit integrierter Signalübertragungsfunktion wird eine Signalübertragungsstruktur mit mehreren elektrischen Leitern bereitgestellt und in ein elektrisch isolierendes Trägermaterial eingebettet, wobei am Bauteil zumindest eine Schnittstelle zum Einspeisen von Signalen in die Leiter und/oder zum Auslesen von Signalen aus den Leitern hergestellt wird.

Bei dem hergestellten Bauteil kann es sich beispielsweise um eine sogenannte Hochvolt-Box für ein elektrisch angetriebenes Kraftfahrzeug handeln. Grundsätzlich kann es sich bei dem Bauteil aber um beliebige Bauteile mit integrierter Signalübertragungsfunktion handeln. Im Falle von sogenannten Hochvolt-Boxen, die üblicherweise aus Aluminium-Druckgussgehäusen bestehen, ist es mit dem erfindungsgemäßen Verfahren möglich, eine solche Hochvolt-Box durch ein Kunststoffmaterial in Form des Trägermaterials zu ersetzen, in welches die als Signalübertragungsstruktur dienenden elektrischen Leiter eingebettet sind.

Die ins Trägermaterial eingebetteten elektrischen Leiter, welche die Signalübertragungsstruktur mit der Signalübertragungsfunktionalität bilden, ermöglichen eine hohe mechanische Belastbarkeit des hergestellten Bauteils, insbesondere im Vergleich mit Bauteilen, die mit herkömmlichen Füllstoffen ausgefüllt sind. Ein üblicherweise als Aluminium-Druckgussgehäuse hergestelltes Bauteil kann mittels des erfindungsgemäßen Verfahrens also durch ein Kunststoffteil mit integriertem Metallgitter ersetzt werden, wobei das Metallgitter durch die Signalübertragungsstruktur und das Kunststoffteil durch das elektrisch isolierende Trägermaterial gebildet wird. Zudem erhöhe sich bei dem erfindungsgemäß hergestellten Bauteil die EMV-Eigenschaften. Ins Bauteil kann zudem beispielsweise noch eine Steuereinheit oder dergleichen integriert werden, welche mit einigen oder mit allen elektrischen Leitern signaltechnisch verbunden ist.

Durch das erfindungsgemäße Verfahren ist es möglich, im besagten Bauteil die Signalübertragungsfunktion zu integrieren. Üblicherweise sonst erforderliche Leitungssätze können dadurch teilweise oder vollständig ersetzt werden. In Folge dessen können manuelle Tätigkeiten zur Realisierung derartiger Signalübertragungsfunktionen reduziert werden, in Folge dessen auch das Prozessrisiko gesenkt werden kann. Insbesondere ist es möglich, das erfindungsgemäße Verfahren vollautomatisiert durchzuführen.

Die in das isolierende Trägermaterial eingebetteten Leiter der Signalübertragungsstruktur bilden mit anderen Worten eine "molded data signal line". Die elektrischen Leiter der Signalübertragungsstruktur stellen Signalverläufe, Signalabgriffe und Übergabestellen dar. Mittels des erfindungsgemäßen Verfahrens ist es also möglich, auf besonders einfache und zuverlässige Weise ein Bauteil mit integrierter Signalübertragungsfunktion bereitzustellen.

Eine mögliche Ausgestaltung des Verfahrens sieht vor, dass die Signalübertragungsstruktur hergestellt wird, indem die Leiter zu einem die Signalübertragungsstruktur bildenden Metallgeflecht geflochten werden. So ist es möglich, die Signalübertragungsstruktur besonders ressourceneffizient herzustellen. Beim Herstellen der Signalübertragungsstruktur entsteht kein oder so gut wie kein Ausschuss, da die Leiter lediglich bereitgestellt, gegebenenfalls abgelenkt und dann zu dem Metallgeflecht verflochten werden müssen.

Eine alternative mögliche Ausgestaltung der Erfindung sieht vor, dass die Signalübertragungsstruktur aus einer Metallplatte hergestellt wird, indem die als Stromschienen ausgebildeten Leiter aus der Metallplatte herausgetrennt werden. Insbesondere ist es möglich, dass die Leiter mittels eines Lasers aus der Metallplatte herausgetrennt werden. Bei der Metallplatte kann es sich beispielsweise um eine Aluminium- oder Kupferplatte handeln, wobei mittels einer Laseranlage entsprechende Stromschienenverläufe herausgeschnitten werden können. Hierbei besteht der große Vorteil, dass jedwede Kontur flexibel dargestellt werden kann und somit mit einer einzigen Anlage viele verschiedene Varianten und Änderungen schnell realisiert werden können. Für die Erstellung neuer Varianten ist damit nur noch eine Neuprogrammierung der entsprechenden Lasersoftware zum Ausschneiden erforderlich.

Eine weitere mögliche Ausgestaltung der Erfindung sieht vor, dass nach dem Verflechten der Leiter zum Metallgeflecht oder nach dem Heraustrennen der Leiter aus der Metallplatte die Leiter in einer dreidimensionalen Struktur umgeformt und danach in das Trägermaterial eingebettet werden. Sofern also nur eine zweidimensionale Kontur bei der Signalübertragungsstruktur erforderlich sein sollte, können die Leiter direkt in das isolierende Trägermaterial eingebettet werden. Ist es hingegen erforderlich beziehungsweise gewünscht, dass die Signalübertragungsstruktur, die aus den elektrischen Leitern besteht, eine dreidimensionale Kontur aufweist, so kann es vorgesehen sein, dass nach dem Verflechten der Leiter zum Metallgeflecht oder nach dem Heraustrennen der Leiter aus der Metallplatte die Leiter in besagte dreidimensionale Struktur umgeformt werden, wonach erst die Leiter in das Trägermaterial eingebettet werden. Durch das Einbetten in das Trägermaterial kann nach der dreidimensionalen Umformung sichergestellt werden, dass diese dreidimensionale Struktur auch erhalten bleibt.

In weiterer möglicher Ausgestaltung der Erfindung ist es vorgesehen, dass die Leiter mittels Prägen oder Formpressen in die dreidimensionale Struktur umgeformt werden. Das Umformen kann flexibel und modular aufgebaut werden, sodass Änderungen und Varianten automatisch während der Fertigung eingestellt werden können.

Eine weitere mögliche Ausgestaltung der Erfindung sieht vor, dass die Leiter in das Trägermaterial eingebettet werden, indem die Leiter mittels eines Spritzgussverfahrens mit dem Trägermaterial umspritzt werden, oder indem das Trägermaterial ein Schmelzklebstoff ist, in welches die Leiter eingebettet werden, oder indem das Trägermaterial eine Folie ist, welche an den Leitern angeordnet wird. Sofern die Leiter mittels des Trägermaterials umspritzt werden, tragen die Leiter und somit trägt die Signalübertragungsstruktur zur mechanischen Stabilisierung des Bauteils bei, wobei im Prinzip jeweilige aus den Leitern gebildete Bahnen als Füllstoff zu betrachten sind. Statt die Leiter der Signalübertragungsstruktur mit dem Trägermaterial zu umspritzen ist es auch möglich, das Trägermaterial in einen Schmelzklebstoff einzubetten oder das Trägermaterial in eine Folie einzubetten. In beiden Fällen ist es möglich, die Leiter in ihrer gewünschten Formgebung zu fixieren.

Eine weitere mögliche Ausgestaltung der Erfindung sieht vor, dass durch Einbetten der Signalübertragungsstruktur in das Trägermaterial zunächst eine Zwischenkomponente hergestellt wird, welche an einer weiteren Komponente unter Ausbildung des Bauteils montiert wird. Die in das Trägermaterial eingebettete Signalübertragungsstruktur bildet also eine Art Einbauteil beziehungsweise Einbaukomponente in Form der Zwischenkomponente. Diese Zwischenkomponente kann dann im Prinzip nach Belieben an einer weiteren Komponente montiert werden, wodurch das Bauteil ausgebildet wird. Auch ist es natürlich möglich, mehrere solcher Zwischenkomponenten mit der integrierten Signalübertragungsstruktur herzustellen und diese an einer weiteren Komponente unter Ausbildung des Bauteils zu montieren. Alternativ ist es auch möglich, dass beim Einbetten der Signalübertragungsstruktur in das Trägermaterial direkt das fertige Bauteil hergestellt wird, beispielsweise mittels eines Spritzgussprozesses. In letzterem Fall kann mittels eines einzigen Verfahrensschritts das gesamte Bauteil mit der integrierten Signalübertragungsstruktur hergestellt werden.

Eine weitere mögliche Ausgestaltung der Erfindung sieht vor, dass die Leiter zumindest teilweise aus Aluminium oder aus Kupfer hergestellt werden. Auch ist es beispielsweise möglich, die Leiter aus verschiedensten Aluminiumlegierungen oder Kupferlegierungen herzustellen. Die Leiter können beispielsweise runde aber auch eckige Querschnitte aufweisen. Beispielsweise ist es auch möglich, dass die Leiter einen hexagonalen Querschnitt aufweisen. Im Falle eines eckigen Querschnitts der Leiter kann dies dazu beitragen, dass die Leiter besonders fest in das Trägermaterial eingebettet werden können. Je nach Anwendungsfall können die Leiter auch unterschiedliche Querschnitte beziehungsweise Breiten aufweisen. So ist es möglich, nicht nur Signale mittels der Leiter zu übertragen, sondern auch beispielsweise höhere Ströme, sofern gewünscht und erforderlich.

Das erfindungsgemäße Bauteil mit einer integrierten Signalübertragungsfunktion umfasst eine Signalübertragungsstruktur mit mehreren Leitern, die in ein elektrisch isolierendes Trägermaterial eingebettet sind, wobei das Bauteil wenigstens eine Schnittstelle zum Einspeisen von Signalen in die Leiter und/oder zum Auslesen von Signalen aus den Leitern aufweist. Die beschriebenen möglichen Ausgestaltungen des Verfahrens sind als mögliche Ausgestaltungen des Bauteils und umgekehrt anzusehen. Bei dem Bauteil kann es sich grundsätzlich um beliebige Bauteile handeln, wobei es sich insbesondere um ein Bauteil für ein Kraftfahrzeug handeln kann, beispielsweise in Form einer Hochvolt-Box oder dergleichen.

Weitere Vorteile, Merkmale und Einzelheiten der Erfindung können sich aus der nachfolgenden Beschreibung möglicher Ausführungsbeispiele sowie anhand der Zeichnung ergeben. Die vorstehend in der Beschreibung genannten Merkmale und Merkmalskombinationen sowie die nachfolgend in der Figurenbeschreibung und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

### Kurze Figurenbeschreibung

Die Zeichnung zeigt in:
- Fig. 1: eine stark schematisierte Darstellung eines Bauteils mit integrierter Signalübertragungsfunktion, welche durch eine Signalübertragungsstruktur mit mehreren elektrischen Leitern realisiert wird, die in ein elektrisch isolierendes Trägermaterial eingebettet ist;
- Fig. 2: eine schematische Darstellung der Signalübertragungsstruktur;
- Fig. 3: eine stark schematisierte Darstellung einer weiteren möglichen Ausführungsform des Bauteils, wobei die in das isolierende Trägermaterial eingebettete Signalübertragungsstruktur eine Zwischenkomponente ist, welche an einer weiteren Komponente unter Ausbildung des Bauteils montiert worden ist.

In den Figuren sind gleiche oder funktionsgleiche Elemente mit den gleichen Bezugszeichen versehen.

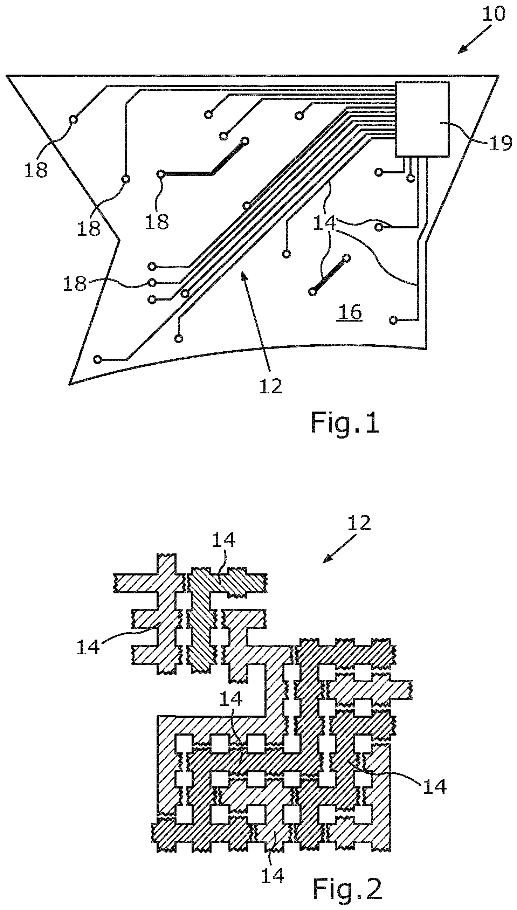

Ein Bauteil 10 mit einer integrierten Signalübertragungsfunktion ist in einer stark schematisierten Darstellung in Fig. 1 gezeigt. Das Bauteil 10 umfasst eine Signalübertragungsstruktur 12, die mehrere elektrische Leiter 14 aufweist, wobei der Übersichtlichkeit halber nicht alle elektrischen Leiter mit einem Bezugszeichen versehen worden sind. Die elektrischen Leiter 14, welche die Signalübertragungsstruktur 12 des Bauteils 10 bilden, sind in ein elektrisch isolierendes Trägermaterial 1 eingebettet. Das Bauteil 10 umfasst zudem mehrere Schnittstellen 18 zum Einspeisen von Signalen in die jeweiligen Leiter 14 und/oder zum Auslesen von Signalen aus den Leitern 14. Des Weiteren weist das Bauteil 10 eine Zentraleinheit 19 auf, in welcher alle Leiter 14 zusammenlaufen.

Die Schnittstellen 18 können teilweise dazu dienen, Signale abzugreifen oder beispielsweise auch als Messstellen dienen. Auch können einige der Schnittstellen 18 dazu dienen, Strom in das Bauteil 10 einzuspeisen oder herauszuführen. Bei dem hier gezeigten Bauteil 10 kann es sich beispielsweise um eine Hochvolt-Box für eine elektrisch angetriebenes Kraftfahrzeug handeln. Grundsätzlich kann es sich bei dem hier dargestellten Bauteil 10 aber um beliebige Bauteile handeln, in das eine Signalübertragungsfunktion in Form der hier schematisch angedeuteten Signalübertragungsstruktur 12 eingebettet ist.

In Fig. 2 ist die Signalübertragungsstruktur 12 in einer schematischen Ansicht gezeigt. Die Signalübertragungsstruktur 12 kann beispielsweise hergestellt werden, indem die einzelnen Leiter 14 zu einem die Signalübertragungsstruktur 12 bildenden Metallgeflecht geflochten werden. Alternativ ist es auch möglich, die Signalübertragungsstruktur 12 aus einer hier nicht dargestellten Metallplatte herzustellen, indem die als Stromschienen ausgebildeten Leiter 14 aus der Metallplatte herausgetrennt werden. Das Heraustrennen kann beispielsweise mittels eines Lasers erfolgen.

Je nach Randbedingung beziehungsweise Anwendungsfall ist es auch möglich, dass die Signalübertragungsstruktur 12 mit einer dreidimensionalen Kontur hergestellt wird. In dem Fall kann es vorgesehen sein, nach dem Verflechten der Leiter 14 zum Metallgeflecht beziehungsweise nach dem Heraustrennen der Leiter 14 aus der besagten Metallplatte die Leiter 14 in eine dreidimensionale Struktur umzuformen, beispielsweise mittels Prägen oder Formpressen, und danach in das Trägermaterial 16 einzubetten.

Das Einbetten der jeweiligen Leiter 14 in das Trägermaterial 16 kann auf unterschiedlichste Arten erfolgen. Beispielsweise kann es vorgesehen sein, die Leiter 14 der Signalübertragungsstruktur 12 mittels eines Spritzgussverfahrens mit dem Trägermaterial 16 zu umspritzen. Alternativ ist es auch möglich, das Trägermaterial 16 in Form eines Schmelzklebstoffs vorzusehen, in welches die Leiter 14 eingebettet werden. Auch ist es möglich, dass das Trägermaterial 16 eine Folie ist, welche an den Leitern 14 angeordnet wird.

Es ist möglich, das Bauteil 10 insbesondere mittels Spritzguss direkt in einem einzigen Arbeitsschritt herzustellen, wobei die fertige Kontur des Bauteils 10 mittels eines Spritzgusswerkzeugs hergestellt wird, in welches beispielsweise die zuvor hergestellte Signalübertragungsstruktur 12 mit den jeweiligen Leitern 14 angeordnet und anschließend mit dem Trägermaterial 16 umspritzt wird.

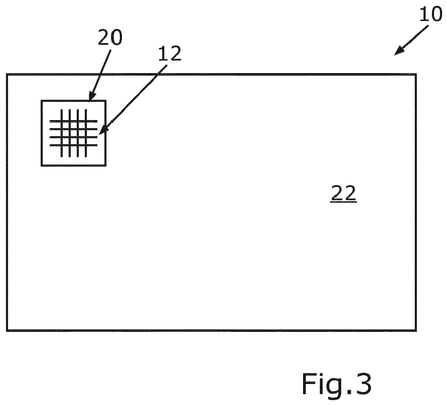

In Fig. 3 ist eine weitere mögliche Ausgestaltung des Bauteils 10 stark schematisiert dargestellt. Durch das Einbetten der Signalübertragungsstruktur 12 in das Trägermaterial 16 kann auch zunächst eine Zwischenkomponente 20 hergestellt werden, welche an einer weiteren hier schematisch angedeuteten Komponente 22 unter Ausbildung des Bauteils 10 montiert werden kann. Auch ist es beispielsweise möglich, mehrere solcher Zwischenkomponenten 20 mit jeweiligen integrierten Signalübertragungsstrukturen 12 herzustellen, sodass mehrere solcher Zwischenkomponenten 20 beispielsweise an dieser weiteren Komponente 22 unter Ausbildung des Bauteils 10 montiert werden können. Wie bereits erwähnt, ist es aber auch möglich, die Signalübertragungsstruktur 12 direkt als integralen Bestandteil des Bauteils 10 herzustellen, insbesondere indem die Signalübertragungsstruktur 12 mittels Spritzguss mit dem Trägermaterial 16 umspritzt wird, aus welchem beispielsweise auch das restliche Bauteil 10 hergestellt werden kann.

Die zur Signalübertragung dienenden elektrischen Leiter 14 können beispielsweise aus Aluminium, aus Aluminiumlegierungen, aus Kupfer, aus Kupferlegierungen oder anderen elektrisch leitenden Materialien hergestellt werden. Die Leiter 14 können dabei beliebige Querschnittsformen aufweisen, beispielsweise rund, sechseckig oder anderweitig ausgebildet sein. Die Leiter 14 bilden eine Art Gitter innerhalb des Bauteils 10 und tragen dazu bei, die mechanische Belastbarkeit des Bauteils 10 zu verbessern. Neben der Signalübertragungsfunktion leisten die Leiter 14 also auch einen Beitrag zur mechanischen Stabilisierung des Bauteils 10.

### BEZUGSZEICHENLISTE

- 10: Bauteil
- 12: Signalübertragungsstruktur
- 14: Leiter
- 16: Trägermaterial
- 18: Schnittstellen
- 19: Zentraleinheit
- 20: Zwischenkomponente
- 22: weitere Komponente

## Patentansprüche

1. Verfahren zum Herstellen eines Bauteils (10) mit integrierter Signalübertragungsfunktion, bei welchem eine Signalübertragungsstruktur (12) mit mehreren elektrischen Leitern (14) bereitgestellt und in ein elektrisch isolierendes Trägermaterial (16) eingebettet wird, wobei am Bauteil (10) zumindest eine Schnittstelle (18) zum Einspeisen von Signalen in die Leiter (14) und/oder zum Auslesen von Signalen aus den Leitern (14) hergestellt wird.

2. Verfahren nach Anspruch 1,
**dadurch gekennzeichnet, dass**
die Signalübertragungsstruktur (12) hergestellt wird, indem die Leiter (14) zu einem die Signalübertragungsstruktur (12) bildenden Metallgeflecht geflochten werden.

3. Verfahren nach Anspruch 1,
**dadurch gekennzeichnet, dass**
die Signalübertragungsstruktur (12) aus einer Metallplatte hergestellt wird, indem die als Stromschienen ausgebildeten Leiter (14) aus der Metallplatte herausgetrennt werden.

4. Verfahren nach Anspruch 3,
**dadurch gekennzeichnet, dass**
die Leiter (14) mittels eines Lasers aus der Metallplatte herausgetrennt werden.

5. Verfahren nach der Ansprüche 2 bis 4,
**dadurch gekennzeichnet, dass**
nach dem Verflechten der Leiter (14) zum Metallgeflecht oder nach dem Heraustrennen der Leiter (14) aus der Metallplatte die Leiter (14) in eine dreidimensionale Struktur umgeformt und danach in das Trägermaterial (16) eingebettet werden.

6. Verfahren nach Anspruch 5,
**dadurch gekennzeichnet, dass**
die Leiter (14) mittels Prägen oder Formpressen in die dreidimensionale Struktur umgeformt werden.

7. Verfahren nach einem der vorhergehenden Ansprüche,
**dadurch gekennzeichnet, dass**
die Leiter (14) in das Trägermaterial (16) eingebettet werden, indem
- die Leiter (14) mittels eines Spritzgussverfahrens mit dem Trägermaterial (16) umspritzt werden, oder
- das Trägermaterial (16) ein Schmelzklebstoff ist, in welches die Leiter (14) eingebettet werden, oder
- das Trägermaterial (16) eine Folie ist, welche an den Leitern (14) angeordnet wird.

8. Verfahren nach einem der vorhergehenden Ansprüche,
**dadurch gekennzeichnet, dass**
durch Einbetten der Signalübertragungsstruktur (12) in das Trägermaterial (16) zunächst eine Zwischenkomponente (20) hergestellt wird, welche an einer weiteren Komponente (22) unter Ausbildung des Bauteils (10) montiert wird.

9. Verfahren nach einem der vorhergehenden Ansprüche,
**dadurch gekennzeichnet, dass**
die Leiter (14) zumindest teilweise aus Aluminium oder Kupfer hergestellt werden.

10. Bauteil (10) mit integrierter Signalübertragungsfunktion, umfassend eine Signalübertragungsstruktur (12) mit mehreren Leitern (14), die in ein elektrisch isolierendes Trägermaterial (16) eingebettet sind, wobei das Bauteil (10) wenigstens eine Schnittstelle (18) zum Einspeisen von Signalen in die Leiter (14) und/oder zum Auslesen von Signalen aus den Leitern (14) aufweist.
